(19) Europäisches Patentamt
European Patent Office
Office européen des brevets

(11) EP 0 679 951 B1

(12) **EUROPEAN PATENT SPECIFICATION**

(45) Date of publication and mention of the grant of the patent:
**15.01.1997 Bulletin 1997/03**

(51) Int Cl.6: **G03F 7/039**

(21) Application number: **95106199.3**

(22) Date of filing: **25.04.1995**

# (54) Positive resist composition

Positive Resistzusammensetzung

Composition pour réserve de type positif

(84) Designated Contracting States:
**DE FR GB IT**

(30) Priority: **25.04.1994 JP 107492/94**
**24.05.1994 JP 132449/94**
**27.10.1994 JP 286168/94**
**27.10.1994 JP 286169/94**
**26.01.1995 JP 28925/95**

(43) Date of publication of application:
**02.11.1995 Bulletin 1995/44**

(73) Proprietor: **TOKYO OHKA KOGYO CO., LTD.**
**Kawasaki-shi Kanagawa, 211 (JP)**

(72) Inventors:
- **Sato, Mitsuru, c/o Tokyo Ohka Kogyo Co., Ltd. Kawasaki-shi, Kanagawa (JP)**
- **Nitta, Kazuyuki, c/o Tokyo Ohka Kogyo Co., Ltd. Kawasaki-shi, Kanagawa (JP)**
- **Yamazaki, Akiyoshi, c/o Tokyo Ohka Kogyo Co., Ltd. Kawasaki-shi, Kanagawa (JP)**
- **Iguchi, Etsuko, c/o Tokyo Ohka Kogyo Co., Ltd. Kawasaki-shi, Kanagawa (JP)**
- **Sakai, Yoshika, c/o Tokyo Ohka Kogyo Co., Ltd. Kawasaki-shi, Kanagawa (JP)**
- **Sato, Kazufumi, c/o Tokyo Ohka Kogyo Co., Ltd. Kawasaki-shi, Kanagawa (JP)**
- **Nakayama, Toshimasa, c/o Tokyo Ohka Kogyo Co.,Ltd. Kawasaki-shi, Kanagawa (JP)**

(74) Representative: **Müller-Boré & Partner Patentanwälte**
**Grafinger Strasse 2**
**81671 München (DE)**

(56) References cited:
**EP-A- 0 520 642** **EP-A- 0 588 544**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 679 951 B1

## Description

The present invention relates to a positive resist composition and, more precisely, to a chemically-amplifying positive resist composition sensitive to UV rays, deep-UV rays, excimer laser beams, X-rays, electron beams, etc., which has a high sensitivity, a high resolution, high heat resistance and good post-exposure storage stability and gives resist patterns with good profiles on substrates without depending on substrates to which it is applied.

Semiconductor devices such as ICs, LSIs, etc, have heretofore been produced by lithography using photoresist compositions to give fine lines on substrates. Concretely, the lithographic process is such that a thin film of a photoresist composition is formed on a silicon wafer, this is exposed to active rays such as UV rays, etc., via a mask pattern for a semiconductor device, and then developed to give a resist pattern, and thereafter the silicon wafer thus having thereon the resist pattern acting as a protective film is etched. As the photoresist composition preferably used in this process, there is known a positive photoresist composition comprising a film forming component like an alkali-soluble novolak resin and a photosensitive component like a quinonediazido group containing compound.

Recently, larger scale integrations in semiconductor devices are desired increasingly, requiring ultra-fine patterning on the order of sub-microns or still quarter microns in the production of ultra-LSIs, etc., with the result that the rays for exposure are trending toward a shorter wavelength, including, for example, g-line, i-line, deep-UV rays and even excimer laser beams, such as KrF laser, etc., and electron beams. At present, lithography using deep-UV rays, excimer laser beams and electron beams is noticed as an important patterning technique in this technical field.

Since the conventional novolak-quinone diazido-resists for g-line and i-line absorb too much amount of radiations, especially deep UV rays and excimer laser beams, it is desired to use chemically-amplifying resists comprising, as the base resin, polyhydroxystyrene which absorb a little amount of the above-mentioned rays.

The above-mentioned chemically-amplifying resists owe their functions to the catalytic activity of acids to be formed by exposure to radiations and have a high sensitivity and a high resolution. They are advantageous in that they may contain only a small amount of a compound capable of generating an acid by exposure to radiations. (Such a compound is hereinafter referred to as "an acid-generating agent".) These chemically-amplifying resists include positive resists and negative resists. The former positive resists are generally composed of an acid-generating agent and a resin component whose solubility in an alkaline aqueous solution is increased by the action of the acid to be generated by said acid-generating agent. (Such a resin component is hereinafter simply referred to as "a resin component".) On the other hand, the latter negative resists are generally composed of an acid-generating agent, a crosslinking agent and an alkali-soluble resin component.

As one example of such chemically-amplifying positive resists, there is known a resist comprising a resin component derived from polyvinylphenol by substituting its hydroxyl groups by tert-butoxycarbonyloxy groups or the like and an acid-generating agent of an onium salt (U.S. Pat. No. 4,491,628). As another example, there is also known a chemically-amplifying positive radiation-sensitive composition comprising a polymer of p-(tert-butoxycarbonyloxy)styrene and an ester of naphthoquinone-1,2-diazido-4-sulfonic acid and bisphenol A (see Japanese Patent Laid-Open No. 3-249654).

However, the above-mentioned, known chemically-amplifying positive resists were not satisfactory in practical use, since the absorption of radiations, especially deep UV rays and excimer laser beams through them is great, and the transmission of radiations not always sufficient, further the sensitivity, the resolution and the heat resistance of these resists are not satisfactory, and since the crosssectional profiles of the patterns to be made of these resists are often broadened upward. In addition, the post-exposure storage stability of these positive resists was not good. Concretely, when these chemically-amplifying positive resists coated on a substrate are exposed, stored for a while and then developed to give patterns, the patterns cannot have good profiles since the acids generated by the exposure are inactivated while the exposed resist films are stored. The problem of post-exposure storage stability is peculiar to chemically-amplifying resists. Moreover, the conventional chemically-amplifying positive resists characteristically depend on substrates to which they are applied, and some of them, when applied to unsuitable substrates, often formed resist patterns with poor profiles expanding downward to the substrates. Therefore, it is an object of the present invention to provide a positive resist composition which transmits radiations, especially deep UV rays and excimer laser beams and which has a high sensitivity, a high resolution, high heat resistance and good post-exposure storage stability.

Another object of the present invention is to provide a positive resist composition capable of forming resist patterns with good profiles, without depending on substrates to which it is applied.

In these situations, we, the present inventors have assiduously studied so as to develop chemically-amplifying positive resist compositions free from the above-mentioned problems and, as a result, have found that a positive resist composition comprising (A) a resin component and (B) an acid-generating agent in which said resin component (A) contains a mixture comprising (a) a polyhydroxystyrene where from 10 to 60 mol% of the hydroxyl groups have been substituted by tert-butoxycarbonyloxy groups and (b) a polyhydroxystyrene where from 10 to 60 mol% of the hydroxyl groups have been substituted by residues of a general formula (I):

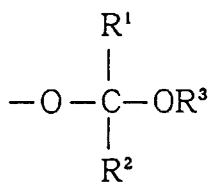

(I)

where $R^1$ represents a hydrogen atom or a methyl group, $R^2$ represents a methyl group or an ethyl group, and $R^3$ represents a lower alkyl group having 1 to 4 carbon atoms.
and also a positive resist composition comprising (A) a resin component, (B) an acid-generating agent and (C) an organic carboxylic acid compound have a high sensitivity, a high resolution, high heat resistance and good post-exposure storage stability and can form resist patterns with good profiles without depending on substrates to which they are applied. On the basis of these findings, we have completed the present invention.

The present invention attains the above-mentioned objects, providing a positive resist composition comprising (A) a resin component and (B) an acid-generating agent, and a positive resist composition comprising (A) a resin component, (B) an acid-generating agent and (C) an organic carboxylic acid compound.

The component (A) to be in the composition of the present invention is a mixture comprising (a) a polyhydroxystyrene where from 10 to 60 mol% of the hydroxyl groups have been replaced by tert-butoxycarbonyloxy groups and (b) a polyhydroxystyrene where from 10 to 60 mol% of the hydroxyl groups have been replaced by residues of a general formula (I):

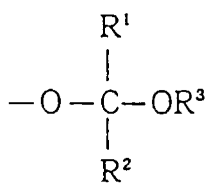

(I)

where $R^1$ represents a hydrogen atom or a methyl group, $R^2$ represents a methyl group or an ethyl group, and $R^3$ represents a lower alkyl group having 1 to 4 carbon atoms.
In this mixture, component (a) is from 10 to 70 % by weight and component (b) is from 30 to 90 % by weight. In this, preferably, component (a) is from 20 to 50 % by weight and component (b) is from 50 to 80 % by weight. Concretely mentioned, as specific examples of the residues of a general formula (I) in the component (b), are 1-methoxyethoxy group, 1-ethoxyethoxy group, 1-n-propoxy-ethoxy group, 1-iso-propoxyethoxy group, 1-n-butoxyethoxy group, 1-iso-butoxyethoxy group, 1-(1,1-dimethylethoxy)-1-methylethoxy group, 1-methoxy-1-methylethoxy group, 1-ethoxy-1-methyl-ethoxy group, 1-n-propoxy-1-methylethoxy group, 1-isobutoxy-1-methylethoxy group, 1-methoxy-n-propoxy group, and 1-ethoxy-n-propoxy group. Among these, especially preferred are 1-ethoxyethoxy group and 1-methoxy-n-propoxy group, since the sensitivity and the resolution of the positive resist composition containing the resin component are well balanced and improved.

In the positive resist composition of the present invention, the acid to be generated by the acid-generating agent partly decomposes the tert-butoxycarbonyloxy groups and the residues of formula (I) by which the solubility of said resin component (A) and the dissolution-inhibiting ability are well balanced, resulting in that the positive resist composition has a high sensitivity, a high resolution and high heat resistance.

The above-mentioned component (a) is a polyhydroxystyrene in which the hydroxyl groups have been partly replaced by tert-butoxycarbonyloxy groups, for example, by a known substitution reaction between an unsubstituted polyhydroxystyrene and di-tert-butyl dicarbonate. In this, the degree of substitution of the hydroxyl groups with tert-butoxycarbonyloxy groups is from 10 to 60 mol%, preferably from 20 to 50 mol%. If said degree of substitution is less than 10 mol%, the positive resist composition containing the resin cannot give resist patterns with good profiles. If, however, it is more than 60 mol%, the sensitivity of said composition is lowered. Therefore, the degree of substitution not falling within the defined range is unfavorable. In practical use of the composition, the degree of substitution is preferably from 20 to 50 mol%.

The above-mentioned component (b) is a polyhydroxystyrene in which the hydroxyl groups have been partly replaced by the residues of formula (I), for example, by a known substitution reaction between an unsubstituted polyhydroxystyrene and 1-chloro-1-ethoxyethane, 1-chloro-1-methoxypropane or the like. In this, the degree of substitution of the hydroxyl groups with such residues is from 10 to 60 mol%, preferably from 20 to 50 mol%. If said degree of substitution is less than 10 mol%, the positive resist composition containing the resin cannot give resist patterns with

good profiles. If, however, it is more than 60 mol%, the sensitivity of said composition is lowered. Therefore, the degree of substitution not falling within the defined range is unfavorable. In practical use of the composition, the degree of substitution is preferably from 20 to 50 mol %.

Each of the above-mentioned resin component shall have a weight-average molecular weight falling within the range between 3,000 and 30,000, measured by gel permeation chromatography (GPC) based on polystyrene. If the weight -average molecular weight is less than the defined range, the coatability of the composition containing the resin is poor. If, however, it is more than the same, the solubility of the resin in an aqueous alkaline solution is lowered.

The acid-generating agent (B) to be in the composition of the present invention is not specifically defined but may be any known acid-generating agent. Concretely mentioned, as agents, are (i) bissulfonyldiazomethanes such as bis (p-toluenesulfonyl)diazomethane, methylsulfonyl -p-toluenesulfonyldiazomethane, 1-cyclohexylsulfonyl-1-(1,1-dimethylethylsulfonyl)diazomethane, bis(1,1-dimethylethylsulfonyl)diazomethane, bis(1-methylethylsulfonyl)diazomethane, bis(cyclohexylsulfonyl)diazomethane, bis(2,4-dimethylphenylsulfonyl)diazomethane, bis-(4-ethylphenylsulfonyl)diazomethane, bis(3-methylphenylsulfonyl)diazomethane, bis(4-methoxyphenyl-sulfonyl)diazomethane, bis (4-fluorophenylsulfonyl)diazomethane, bis(4-chloro-phenyl-sulfonyl)diazomethane, and bis(4-tert-butylphenylsulfonyl) diazomethane; (ii) sulfonylcarbonyl alkanes such as 2-methyl-2-(p-toluenesulfonyl)propiophenone, 2-(cyclohexylcarbonyl)-2-(p-toluenesulfonyl)propane, 2-methanesulfonyl -2-methyl-(4-methylthio)propiophenone, and 2,4-dimethyl -2-(p-toluenesulfonyl)pentane-3-one; (iii) sulfonyl carbonyldiazomethanes such as 1-p-toluenesulfonyl-1-cyclo-hexylcarbonyldiazomethane, 1-diazo-1-methylsulfonyl-4-phenyl-2-butanone, 1-cyclohexylsulfonyl-1-cyclohexyl-carbonyldiazomethane, 1-diazo-1-cyclohexylsulfonyl-3,3-di-methyl-2-butanone, 1-diazo-1-(1,1-dimethylethylsulfonyl)-3,3-dimethyl-2-butanone, 1-acetyl-1-(1-methylethyl-sulfonyl)diazomethane, 1-diazo-1-(p-toluenesulfonyl)-3,3-dimethyl-2-butanone, 1-diazo-1-benzenesulfonyl-3,3-dimethyl-2-butanone, 1-diazo-1-(p-toluenesulfonyl)-3-methyl -2-butanone, 2-diazo-2-(p-toluenesulfonyl)cyclohexyl-acetate, 2-diazo-2-benzenesulfonyl tert-butyl acetate, 2-diazo-2-methanesulfonyl isopropyl acetate, 2-diazo-2-benzenesulfonyl cyclohexyl acetate, and 2-diazo-2-(p-toluenesulfonyl)tert-butyl acetate; (iv) nitrobenzyl derivatives such as 2-nitrobenzyl-p-toluenesulfonate, 2,6-dinitrobenzyl-p-toluenesulfonate, and 2,4-dinitrobenzyl-p-trifluoro-methylbenzenesulfonate; and (v) esters of polyhydroxy compounds and aliphatic or aromatic sulfonic acids such as pyrogallic methane sulfonate ester, pyrogallic benzene sulfonate ester(pyrogallol trimesylate), pyrogallic p-toluene sulfonate ester, pyrogallic p-methoxy benzene sulfonate ester, pyrogallic mesitylene sulfonate ester, pyrogallic benzylsulfonate ester, alkyl gallic acid methane sulfonate ester, alkyl gallic acid benzene sulfonate ester, alkyl gallic acid p-toluene sulfonate ester, alkyl gallic acid p-methoxy benzene sulfonate ester, alkyl gallic acid mesitylene sulfonate ester, and alkyl gallic acid benzylsulfonate ester. Preferred are the alkyl group in the aforementioned alkyl gallic acid where the alkyl group has from 1 to 15 carbon atoms, and especially octyl group or lauryl group. Also(vi) onium salt-based acid-generating agents represented by the following general formulas (II) and (III) and (vii) benzoin tosylate-based acid-generating agents represented by the general formula (IV) may be used :

$$R^4\text{-}I^+\text{-}R^5X^- \qquad \text{(II)}$$

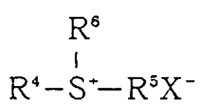

(III)

wherein $R^4$, $R^5$, and $R^6$ are aryl groups or aryl groups having a substituent and may be respectively identical or different; $X^-$ is any of $AsF_6^-$, $SbF_6^-$, $PF_6^-$ $BF_4^-$, or $CF_3SO_3$,

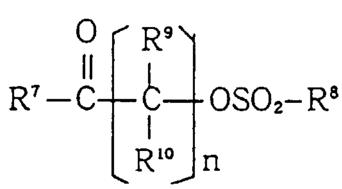

(IV)

wherein $R^7$ and $R^8$ are aryl groups or aryl groups having a substituent and may be identical or different; $R^9$ and $R^{10}$ are hydrogen atoms, lower alkyl groups, hydroxyl groups, or aryl groups and may be identical or different and n is 0 or 1.

In the following there are shown specific onium salts represented by general formulas (II) and (III):

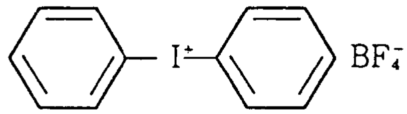

diphenyliodonium tetrafluoroborate

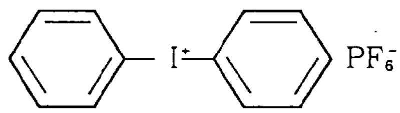

diphenyliodonium hexafluorophosphate

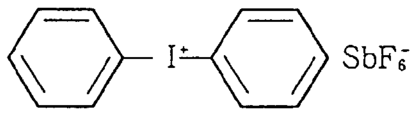

diphenyliodonium hexafluoroantimonate

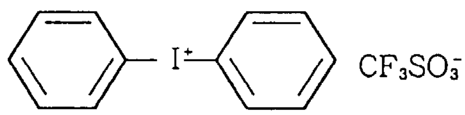

diphenyliodonium trifluoromethane sulfonate

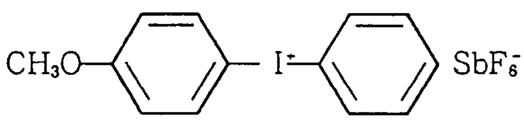

(4-methoxyphenyl)phenyliodonium hexafluoro antimonate

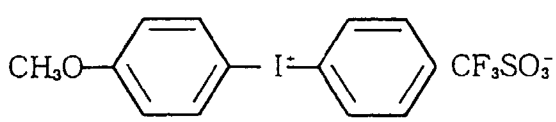

(4-methoxyphenyl)phenyliodonium trifluoromethane sulfonate

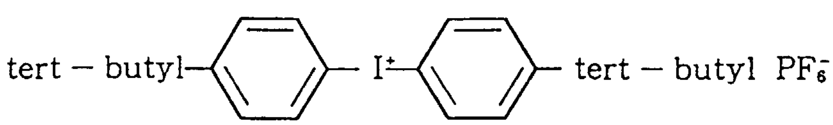

bis(p-tert-butylphenyl)iodonium hexafluorophosphate

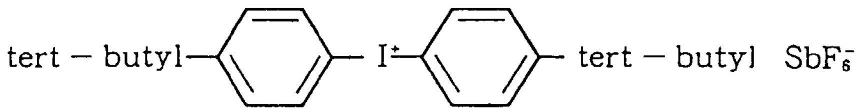

bis(p-tert-butylphenyl)iodonium hexafluoroantimonate

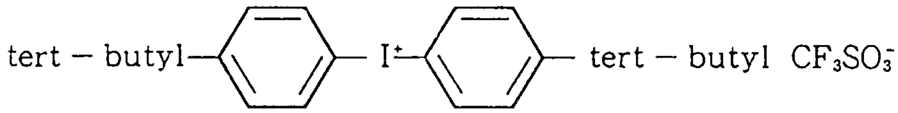

bis(p-tert-butylphenyl)iodonium trifluoromethane sulfonate

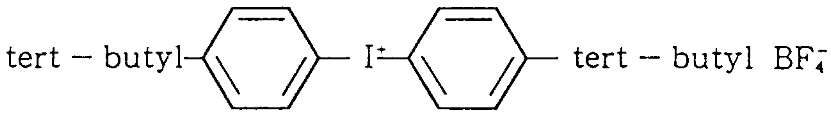

bis(p-tert-butylphenyl)iodonium tetrafluoroborate

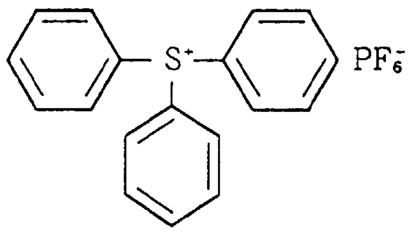

triphenylsulfonium hexafluorophosphate

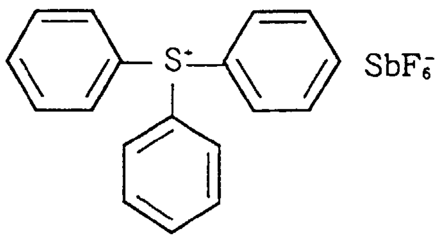

triphenylsulfonium hexafluoroantimonate

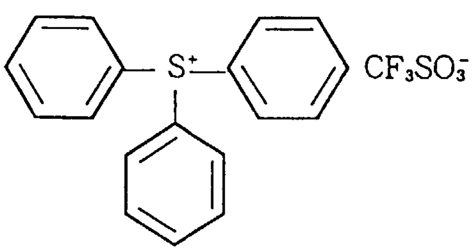

triphenylsulfonium trifluoromethane sulfonate

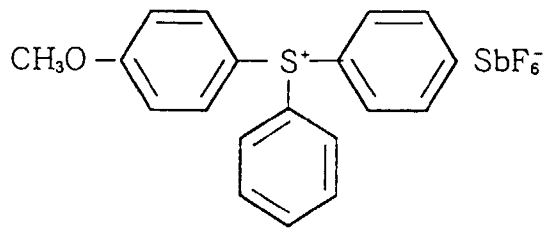

(4-methoxyphenyl)diphenylsulfonium hexafluoro antimonate

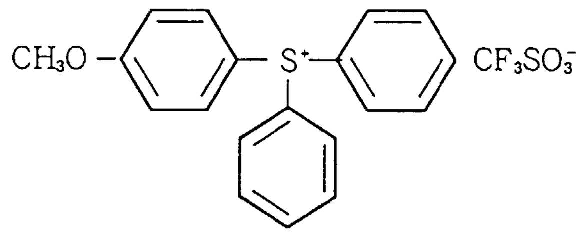

(4-methoxyphenyl)diphenylsulfonium trifluoromethane sulfonate

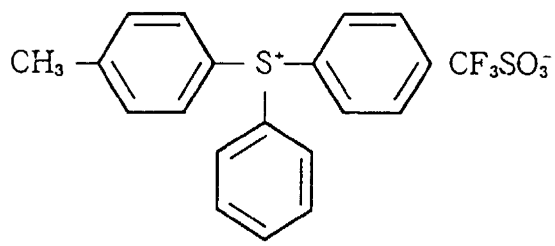

(4-methylphenyl)diphenylsulfonium trifluoromethane sulfonate

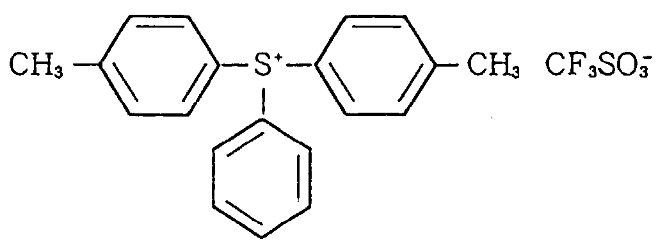

bis(4-methylphenyl)phenylsulfonium trifluoromethane sulfonate

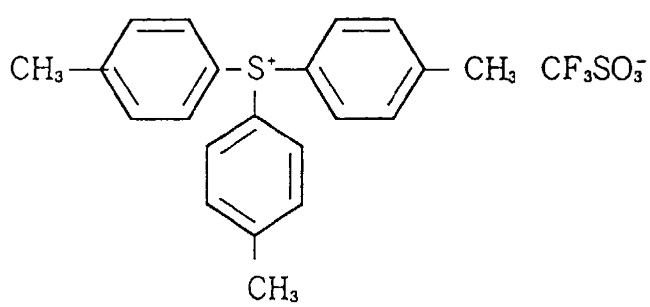

tris(4-methylphenyl)sulfonium trifluoromethane sulfonate

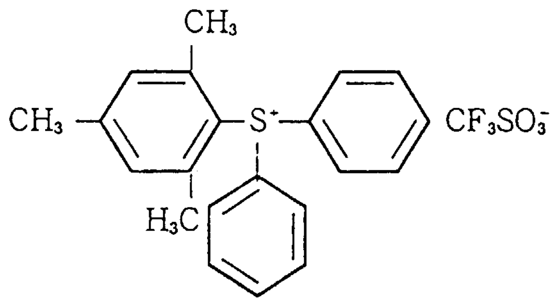

(2,4,6-trimethylphenyl)diphenylsulfonium trifluoro methane sulfonate

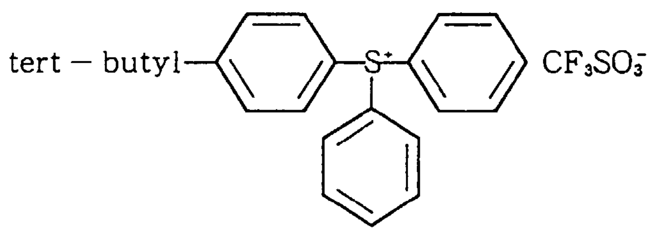

(4-tert-butyl-phenyl)diphenylsulfonium trifluoro methane sulfonate

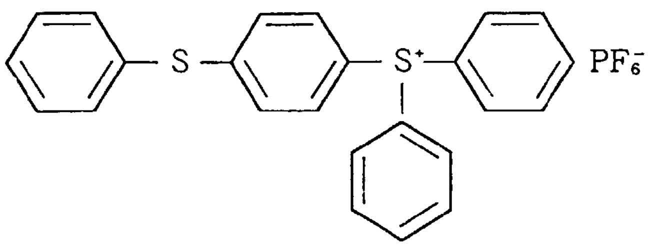

diphenyl[4-(phenylthio)phenyl]sulfonium hexafluoro phosphate

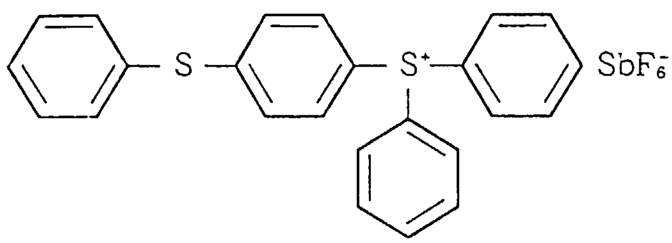

diphenyl[4-(phenylthio)phenyl]sulfonium hexafluoro antimonate

Among these onium salts, onium salts wherein trifluoromethanesulfonate forms a negative ion are favorable because they do not contain phosphorous, boron, antimony, or other atoms used as dispersing agents during semiconductor element manufacturing.

(vii) The following compounds are shown as specific benzoin tosylate-based acid-forming agents.

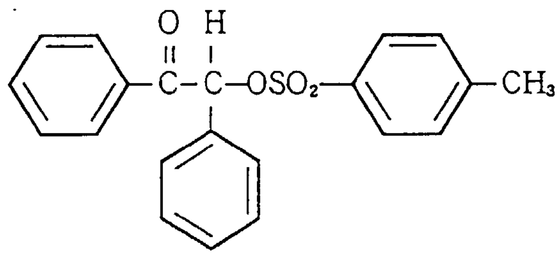

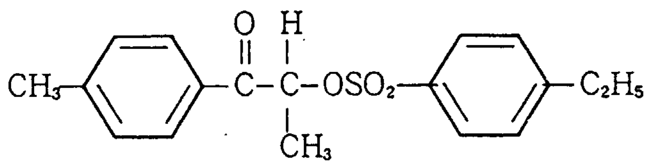

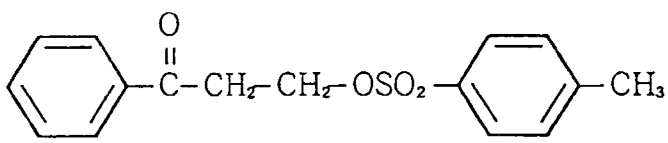

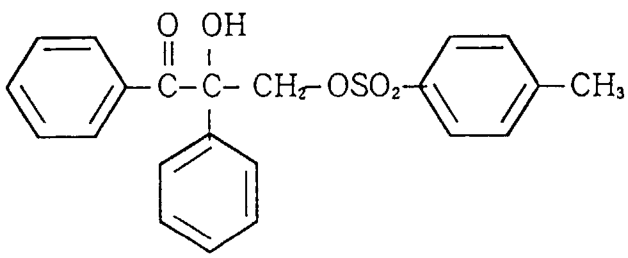

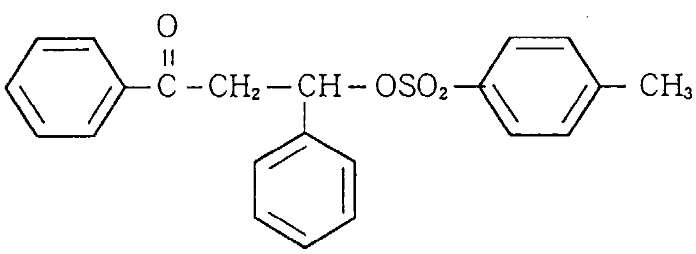

One of these acid-forming agents may be used, or two or more may be used in combination. Among these, as the acid-generating agents to be in the resists for excimer laser beams, especially preferred are bissulfonyl diazomethanes, particularly bis(cyclohexylsulfonyl)diazomethane and bis(2,4-dimethylphenylsulfonyl)diazomethane.

As the acid-generating agents to be in the resists for electron beams, other acid-generating agents than the above-mentioned (i) and (iii) can be employed. Especially preferred are nitrobenzyl derivatives of (iv), particularly 2,6-dinitrobenzyl-p-toluenesulfonate; esters of polyhydroxy compounds and aliphatic or aromatic sulfonic acids of (V), particularly pyrogallol trimesylate; onium salts of (vi), particularly bis(p-tert-butylphenyl)iodonium trifluoromethanesulfonate, triphenylsulfoniumtrifluoromethanesulfonate; and (vii) benzoin tosylate type acid-generating agents.

The proportion of the above-mentioned acid-generating agent to be in the composition of the present invention may be from 1 to 20 parts by weight, preferably from 2 to 10 parts by weight, relative to 100 parts by weight of the resin component (A) in the composition. If the proportion of the acid-generating agent is less than 1 part by weight, the agent insufficiently exhibits its effect. If, however, it is more than 20 parts by weight, such too much amount of the agent cannot be completely dissolved in a solvent and, in addition, the miscibility of the agent with the resin component is

lowered.

An organic carboxylic acid compound (C) may be added to the resist composition of the present invention, and the composition containing it gives resist patterns with good profiles. In particular, the composition containing an organic carboxylic acid compound has good post exposure storage stability, while giving resist patterns with good profiles on various substrates.

The organic carboxylic acid compound (C) to be in the composition of the present invention is not specifically defined but may be any of saturated or unsaturated aliphatic carboxylic acids, alicyclic carboxylic acids, hydroxy-carboxylic acids, alkoxy-carboxylic acids, ketocarboxylic acids, aromatic carboxylic acids, etc. For example, the acid compound (C) includes aliphatic mono- or polycarboxylic acids such as formic acid, acetic acid, propionic acid, butyric acid, isobutyric acid, oxalic acid, malonic acid, succinic acid, glutaric acid, and adipic acid; alicyclic carboxylic acids such as 1,1-cyclohexanedicarboxylic acid, 1,2-cyclohexanedicarboxylic acid, 1,3-cyclohexanedicarboxylic acid, 1-4-cyclohexanedicarboxylic acid, and 1,1-cyclohexyldiacetic acid; unsaturated aliphatic carboxylic acids such as acrylic acid, crotonic acid, isocrotonic acid, 3-butenoic acid, methacrylic acid, 4-pentenoic acid, propiolic acid, 2-butynoic acid, maleic acid, fumaric acid, and acetylenecarboxylic acid; hydroxycarboxylic acids such as hydroxyacetic acid; alkoxy-carboxylic acids such as methoxyacetic acid and ethoxyacetic acid; keto carboxylic acids such as pyruvic acid; and aromatic carboxylic acid compounds described by a general formula (V)

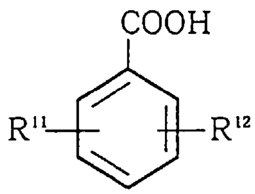

(V)

wherein $R^{11}$ and $R^{12}$ each independently represent a hydrogen atom, a hydroxyl group, a nitro group, a carboxyl group or a vinyl group, provided that both $R^{11}$ and $R^{12}$ should not be hydrogen atoms
or those of a general formula (VI):

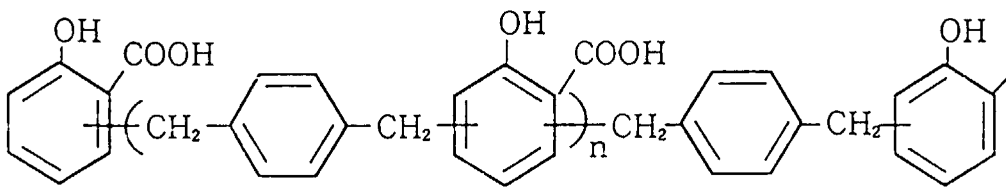

(VI)

wherein n represents 0 or an integer of from 1 to 10),
etc.

Of these, especially preferred are alicyclic-carboxylic acid compounds, unsaturated aliphatic carboxylic acid compounds and aromatic carboxylic acid compounds.

As examples of the aromatic carboxylic acid compounds of formula (V), mentioned are p-hydroxybenzoic acid, o-hydroxybenzoic acid, 2-hydroxy-3-nitrobenzoic acid, 3,5-dinitrobenzoic acid, 2-nitrobenzoic acid, 2,4-dihydroxybenzoic acid, 2,5-dihydroxybenzoic acid, 2,6-dihydroxybenzoic acid, 3,4-dihydroxybenzoic acid, 3,5-dihydroxybenzoic acid, 2-vinylbenzoic acid, 4-vinylbenzoic acid, phthalic acid, terephthalic acid, and iso-phthalic acid, etc. Especially preferred are benzoic acids having an o-positioned substituent, such as o-hydroxybenzoic acid, 2-nitrobenzoic acid and phthalic acid, etc.

The aromatic carboxylic acid compounds of formula (VI) can be used either as a single compound where n is a singular number or as a combination of two or more different compounds. In practical use, the composition of the present invention preferably contains, as the acid compound, SAX (trade name, produced by Mitsui Toatsu Chemical Co.) which is sold as a phenolic compound.

One or more of the above-mentioned aromatic carboxylic acid compounds of formula (V) and (VI) can be in the composition of the present invention. The composition of the present invention containing any of these aromatic carboxylic acids gives resist patterns with good profiles. In addition, the composition has good post-exposure storage stability and therefore always gives resist patterns with good profiles without depending on the period of time needed after the exposure of the composition and before the heating treatment thereof. In particular, the aromatic carboxylic acid compounds of formula (VI) are preferred, since the composition of the present invention containing any of them gives resist patterns with true rectangular profiles.

The proportion of the above-mentioned organic carboxylic acid compound (C) to be in the composition of the present invention may be from 0.01 to 1 % by weight, preferably from 0.05 to 0.5 % by weight, more preferably from 0.07 to 0.3 % by weight, relative to the sum of the resin component and the acid-generating agent to be in the composition. If the proportion of the organic carboxylic acid compound is less than 0.01 % by weight, the composition cannot give resist patterns with good profiles. If, however, it is more than 1 % by weight, the developability of the composition is lowered. Therefore, the proportion of the acid compound not falling within the defined range is unfavorable.

The positive resist composition of the present invention preferably contains, in addition to the above-mentioned components, a light-absorbing agent so as to have a higher sensitivity and a higher resolution. As examples of the light-absorbing agent, mentioned are mercaptoxazole, mercaptobenzoxazole, merocaptoxazoline, mercaptobenzothiazole, benzoxazolinone, benzothiazolone, mercaptobenzimidazole, urazole, thiouracil, mercapto pyrimidine, benzophenone and their derivatives. In particular, benzophenone is preferred, since its ability to improve the sensitivity and the resolution of the composition containing it is excellent and since it additionally has the ability to inhibit the influence of standing waves on the resist composition thereby making the composition not into resist patterns with waved profiles but into resist patterns with true rectangular profiles. The proportion of the light-absorbing agent to be in the composition of the present invention may be not more than 30 % by weight, preferably from 0.5 to 15 % by weight, relative to the sum of the components (A) and (B). If the proportion of the agent is more than 30 % by weight, the profiles of the resist patterns to be given by the composition containing it are unfavorably worsened.

It is desirable that the positive resist composition of the present invention is used as a solution comprising the above-mentioned components dissolved in a solvent. As examples of the solvent, mentioned are ketones such as acetone, methyl ethyl ketone, cyclohexanone, and methyl isoamyl ketone; polyhydric alcohols or derivatives thereof such as ethylene glycol, ethylene glycol monoacetate, diethylene glycol, diethylene glycol monoacetate, propylene glycol, propylene glycol monoacetate, dipropylene glycol, and dipropylene glycol monoacetate as well as ethers thereof, for example monomethyl ethers, monoethyl ethers, monopropyl ethers, monobutyl ethers and monophenyl ethers; cyclic ethers such as dioxane; and esters such as methyl lactate, ethyl lactate, methyl acetate, ethyl acetate, butyl acetate, methyl pyruvate, ethyl pyruvate, methyl methoxypropionate, and ethyl ethoxy propionate, etc. These solvents can be used singly or as a mixture of two or more of them.

The positive resist composition of the present invention may contain, if desired, conventional miscible additives, such as additional resins to improve the properties of the resist films, as well as a plasticizer, a stabilizer, a colorant, a surfactant, etc.

The positive resist composition of the present invention is dissolved in a solvent, and the resulting solution is coated on a substrate coated with an insulating film such as silicon nitride (SiN), BPSG (Boron Phosphorus Silicate Glass) or the like film or on a substrate coated with a metallic film such as titanium nitride (TiN), Al-Si-Cu, tungsten or the like film, using a spinner or the like, dried to form a photosensitive layer on said substrate, exposed to deep-UV rays, excimer laser beams via a desired mask pattern or subjected to imaging with electron beams, using a minifying projection exposure machine or the like, and developed with a developer such as a weakly-alkaline aqueous solution containing from 1 to 10 % by weight of tetramethylammonium hydroxide or the like. After this process, a good resist pattern faithful to the mask pattern used is formed on the substrate, not depending on the kind of the substrate used.

Next, the present invention is described in more detail by means of the following production examples and working examples, which, however, are not intended to restrict the scope of the present invention.

Production Example 1

(Production of polyhydroxystyrene where 8 mol % of the hydroxyl groups have been replaced by tert-butoxycarbonyloxy groups)

120 g of polyhydroxystyrene having a weight-average molecular weight of 20,000 were dissolved in 680 g of N, N-dimethylacetamide, and 17.4 g of di-tert-butyl dicarbonate were added to the resulting solution and stirred to completely dissolve them. Next, 59 g of triethylamine were dropwise added thereto over a period of about 15 minutes with still stirring. After the addition, this mixture was further stirred for about 3 hours. Next, to the resulting solution added was pure water of 20 times the solution. This was further stirred to make polyhydroxystyrene where the hydroxyl groups had been partly substituted by tert-butoxycarbonyloxy groups precipitated therein. The thus-precipitated product was washed with pure water, dewatered and dried to obtain 125 g of polyhydroxystyrene where 8 mol% of the hydroxyl groups had been replaced by tert-butoxycarbonyloxy groups.

Production Example 2

(Production of polyhydroxystyrene where 35 mol% of the hydroxyl groups have been replaced by tert-butoxycarbonyloxy groups)

145g of polyhydroxystyrene where 35 mol% of the hydroxyl groups had been substituted by tert-butoxy carbonyloxy groups were obtained as in the same manner in Production Example 1, except that the added weight of di-tert-butyl dicarbonate was changed to 76.5g.

Production Example 3

(Production of polyhydroxystyrene where 39 mol% of the hydroxyl groups have been replaced by tert-butoxycarbonyloxy groups)

150g of polyhydroxystyrene where 39 mol% of the hydroxyl groups had been substituted by tert-butoxycarbonyloxy groups were obtained as in the same manner in Production Example 1, except that the added weight of di-tert-butyl dicarbonate was changed to 85.0g.

Production Example 4

(Production of polyhydroxystyrene where 70 mol% of the hydroxyl groups have been replaced by tert-butoxycarbonyloxy groups)

180g of polyhydroxystyrene where 70 mol% of the hydroxyl groups had been substituted by tert-butoxycarbonyloxy groups were obtained as in the same manner in Production Example 1, except that the added weight of di-tert-butyl dicarbonate was changed to 153g.

Production Example 5

(Production of polyhydroxystyrene where 35 mol% of the hydroxyl groups have been replaced by ethoxyethoxy groups)

120 g of polyhydroxystyrene having a weight-average molecular weight of 20,000 were dissolved in 680 g of N, N-dimethylacetamide, and 37.2 g of 1-chloro-1-ethoxyethane were added to the resulting solution and stirred to completely dissolve them. Next, 78. 8 g of triethylamine were dropwise added thereto over a period of about 30 minutes with still stirring. After the addition, this mixture was further stirred for about 3 hours. Next, to the resulting solution added was pure water of 20 times the solution. This was further stirred. Thus, 130 g of polyhydroxystyrene where 35 mol% of the hydroxyl groups had been partly replaced by 1-ethoxyethoxy groups were obtained.

Production Example 6

(Production of polyhydroxystyrene where 8 mol % of the hydroxyl groups have been replaced by methoxy-n-propyloxy groups)

120 g of polyhydroxystyrene having a weight-average molecular weight of 20,000 were dissolved in 680 g of N, N-dimethylacetamide, and 8.6 g of 1-chloro-1-methoxypropane were added to the resulting solution and stirred to completely dissolve them. Next, 78.8 g of triethylamine were dropwise added thereto over a period of about 30 minutes with still stirring. After the addition, this mixture was further stirred for about 3 hours. Next, to the resulting solution added was pure water of 20 times the solution. This was further stirred to make polyhydroxystyrene where the hydroxyl groups had been partly substituted by 1-methoxy-n-propyloxy groups precipitated therein. The thus-precipitated product was washed, dewatered and dried to obtain 125 g of polyhydroxystyrene where 8 mol% of the hydroxyl groups had been replaced by 1-methoxy-n-propyloxy groups.

Production Example 7

(Production of polyhydroxystyrene where 39 mol% of the hydroxyl groups have been replaced by methoxy-n-propyloxy groups)

130g of polyhydroxystyrene where 39 mol% of the hydroxyl groups had been replaced by 1-methoxy-n-propyloxy

groups were obtained in the same manner as in Production Example 6, except that the added weight of 1-chloro-1-methoxypropane was changed to 42.3g.

Production Example 8

(Production of polyhydroxystyrene where 70 mol % of the hydroxyl groups have been replaced by methoxy-n-propyloxy groups)

150g of polyhydroxystyrene where 70 mol% of the hydroxyl groups had been replaced by 1-methoxy-n-propyloxy groups were obtained in the same manner as in Production Example 6, except that the added weight of 1-chloro-1-methoxypropane was changed to 75.6g.

Example 1

1.48 g of polyhydroxystyrene obtained in Production Example 2, in which 35 mol% of the hydroxyl groups had been replaced by tert-butoxycarbonyloxy groups, and 1.48 g of polyhydroxystyrene obtained in Production Example 5, in which 35 mol% of the hydroxyl groups had been replaced by ethoxyethoxy groups, were dissolved in 16.8 g of propylene glycol monomethyl ether acetate, and 0.148 g of bis(cyclohexyl-sulfonyl)diazomethane and 0.093 g of benzophenone were added thereto and dissolved. The resulting solution was filtered through a 0.2 µm membrane filter to obtain a coating liquid of positive resist.

The thus-prepared coating liquid was coated on a 6 inches silicon wafer, using a spinner, and dried on a hot plate at 90 °C for 90 seconds to form a resist film having a thickness of 0.7 µm on the wafer. This was exposed via a test chart mask, using a minifying projection exposure machine, NSR-2005EX8A (produced by Nicon Co.), heated at 120 °C for 90 seconds, then developed by paddling it in an aqueous solution of 2. 38 % by weight of tetramethylammonium hydroxide for 65 seconds, washed with water for 30 seconds, and dried to form a resist pattern on the wafer. The resist pattern thus formed was a 0.21 µm line-and-space pattern. The cross sectional profile of the resist pattern was good and almost rectangular, though somewhat trapezoidal. The resist pattern was not influenced by standing waves. The minimum exposure amount, at which the resist coated was patterned into a large-area resist pattern detectable with the naked eye while the surface of the substrate was exposed to be seen, (this is hereinafter simply referred to as "minimum exposure amount") was measured to be 7 $mJ/cm^2$. The heat resistance of the 0.5 µm line pattern formed from the resist was measured to be at 130 °C.(The heat resistance as referred to herein means the temperature at which the pattern formed begins to flow under heat.) Apart from this, the resist film coated on the wafer was exposed, then left as it was for 15 minutes and thereafter heated at 120 °C for 90 seconds. This was processed in the same manner as above. However, the cross sectional profile of the resist pattern formed was T-shaped, and the finest patterning limit of the resist was to give a 0.3 µm line-and-space pattern.

Example 2

A resist pattern was formed in the same manner as in Example 1, except that benzophenone was not added to the coating liquid of positive resist. The resist pattern thus formed was a 0.21 µm line-and-space pattern. The cross-sectional profile of the resist pattern was good and almost rectangular, though somewhat waved but in a negligible degree for practical use. The minimum exposure amount for the resist was measured to be 6 $mJ/cm^2$. The heat resistance of the 0.5 µm line-space pattern formed from the resist was measured to be at 130 °C.

Comparative Example 1

2.96 g of polyhydroxystyrene obtained in Production Example 2, in which 35 mol% of the hydroxyl groups had been replaced by tert-butoxycarbonyloxy groups, were dissolved in 16.8 g of propylene glycol monomethyl ether acetate, and 0.148 g of bis(cyclohexylsulfonyl)diazomethane and 0.093 g of benzophenone were added thereto and dissolved. The resulting solution was filtered through a 0.2 µm membrane filter to obtain a coating liquid of positive resist.

Using the thus-prepared coating liquid, a resist pattern was formed in the same manner as in Example 1. However, the finest patterning limit of the resist was to give a 0.28 µm line-and-space pattern. The cross-sectional profile of the pattern thus formed was not good, as being expanded downward to the substrate. The minimum exposure amount for the resist was measured to be 35 $mJ/cm^2$. The heat resistance of the 0.5 µm line-space pattern formed from the resist was measured to be at 150 °C.

Comparative Example 2

2.96 g of polyhydroxystyrene obtained in Production Example 5, in which 35 mol% of the hydroxyl groups had been replaced by ethoxyethoxy groups, were dissolved in 16.8 g of propylene glycol monomethyl ether acetate, and 0.148 g of bis(cyclohexylsulfonyl)diazomethane and 0.093 g of benzophenone were added thereto and dissolved. The resulting solution was filtered through a 0.2 μm membrane filter to obtain a coating liquid of positive resist.

Using the thus-prepared coating liquid, a resist pattern was formed in the same manner as in Example 1. However, the finest patterning limit of the resist was to give a 0.25 μm line-and-space pattern, The cross-sectional profile of the pattern thus formed was not good, having an inverted triangular shape. The minimum exposure amount for the resist was measured to be 7 mJ /$cm^2$. The heat resistance of the 0.5 μm line-space pattern formed from the resist was measured to be at 120 °C.

Example 3

1.48 g of polyhydroxystyrene(having a weight-average molecular weight of 20,000) obtained in Production Example 2, in which 35 mol% of the hydroxyl groups had been replaced by tert-butoxycarbonyloxy groups, and 1.48 g of polyhydroxystyrene (having a weight-average molecular weight of 20,000) obtained in Production Example 5, in which 35 mol% of the hydroxyl groups had been replaced by ethoxyethoxy groups, were dissolved in 16.8 g of propylene glycol monomethyl ether acetate, and 0.148 g of bis(cyclohexylsulfonyl)diazomethane, 0.093 g of benzophenone and 0. 0032 g of o-hydroxybenzoic acid were added thereto and dissolved. The resulting solution was filtered through a 0.2 μm membrane filter to obtain a coating liquid of positive resist.

The thus-prepared coating liquid was coated on a 6 inches silicon wafer, using a spinner, and dried on a hot plate at 90 °C for 90 seconds to form a resist film having a thickness of 0.7 μm on the wafer. This was exposed to excimer laser via a test chart mask, using a minifying projection exposure machine, NSR-2005EX8A(produced by Nicon Co.), heated at 120 °C for 90 seconds, then developed by paddling it in an aqueous solution of 2.38 % by weight of tetramethylammonium hydroxide for 65 seconds, washed with water for 30 seconds, and dried to form a resist pattern on the wafer. The resist pattern thus formed was a 0.21 μm line-and-space pattern. The cross sectional profile of the resist pattern was good and almost rectangular, though somewhat roundish at the top. The resist pattern was not influenced by standing waves. The minimum exposure amount was measured to be 7 mJ/$cm^2$. The heat resistance of the 0.5 μm line pattern formed from the resist was measured to be at 130 °C.

Using this resist, a resist pattern was formed in the same manner as above, except that the resist was, after exposed, left as it was for 15 minutes and then heated at 120 °C for 90 seconds. The resist pattern thus formed was a 0.21 μm line-and-space pattern having a good, rectangular cross sectional profile.

Example 4

A resist pattern was formed in the same manner as in Example 3, except that benzophenone was not added to the coating liquid of positive resist. The resist pattern thus formed was a 0.23 μm line-and-space pattern. The cross sectional profile of the resist pattern was good and almost rectangular, though somewhat roundish at the top and waved but in a negligible degree for practical use. The minimum exposure amount for the resist was measured to be 8 mJ/$cm^2$. The heat resistance of the 0. 5 μm line-space pattern formed from the resist was measured to be at 130 °C.

Using this resist, a resist pattern was formed in the same manner as in Example 1, except that the resist was, after exposed, left as it was for 15 minutes and then heated at 120 °C for 90 seconds. The resist pattern thus formed was a 0.23 μm line-and-space pattern having a good cross sectional profile.

Example 5

A resist pattern was formed in the same manner as in Example 3, except that 0.0062 g of SAX (trade name, produced by Mitsui Toatsu Chemical Co.), which is sold as a phenolic compound, were used in place of o-hydroxybenzoic acid. The resist pattern thus formed was a 0.21 μm line-and-space pattern. The cross sectional profile of the resist pattern was good and rectangular, without being influenced by standing waves. The minimum exposure amount for the resist was measured to be 7 mJ/$cm^2$. The heat resistance of the 0.5 μm line-space pattern formed from the resist was measured to be at 130 °C.

Using this resist, a resist pattern was formed in the same manner as in Example 1, except that the resist was, after exposed, left as it was for 15 minutes and then heated at 120 °C for 90 seconds. The resist pattern thus formed was a 0.21 μm line-and-space pattern having a good, rectangular cross-sectional profile.

Example 6

A resist pattern was formed in the same manner as in Example 3, except that 0.0062 g of acrylic acid were used in place of o-hydroxybenzoic acid. The resist pattern thus formed was a 0.21 μm line-and-space pattern. The cross-sectional profile of the resist pattern was good and rectangular, without being influenced by standing waves. The minimum exposure amount for the resist was measured to be 7 mJ/cm$^2$. The heat resistance of the 0. 5 μm line-space pattern formed from the resist was measured to be at 130 °C.

Using this resist, a resist pattern was formed in the same manner as in Example 1, except that the resist was, after exposed, left as it was for 15 minutes and then heated at 120 °C for 90 seconds. The resist pattern thus formed was a 0.21 μm line-and-space pattern having a good, rectangular cross sectional profile.

Example 7

1.05 g of polyhydroxystyrene obtained in Production Example 3, in which 39 mol% of the hydroxyl groups had been replaced by tert-butoxycarbonyloxy groups, and 1.95 g of polyhydroxystyrene obtained in Production Example 7, in which 39 mol% of the hydroxyl groups had been replaced by 1-methoxy-n-propyloxy groups, were dissolved in 16. 8 g of propylene glycol monomethyl ether acetate, and 0.21 g of bis(cyclohexylsulfonyl)diazomethane and 0. 009 g of o-nitrobenzoic acid were added thereto and dissolved. The resulting solution was filtered through a 0.2 μm membrane filter to obtain a coating liquid of positive resist.

The thus-prepared coating liquid was coated on a 6 inches silicon wafer, using a spinner, and dried on a hot plate at 90 °C for 90 seconds to form a resist film having a thickness of 0.7 μm on the wafer. This was exposed via a test chart mask, using a minifying projection exposure machine, NSR-2005EX8A (produced by Nicon Co.), heated at 110 °C for 90 seconds, then developed by paddling it in an aqueous solution of 2.38 % by weight of tetramethylammonium hydroxide for 65 seconds, washed with water for 30 seconds, and dried to form a resist pattern on the wafer. The resist pattern thus formed was a 0.22 μm line-and-space pattern. The cross sectional profile of the resist pattern was good and rectangular, though somewhat waved but in a negligible degree for practical use. The minimum exposure amount was measured to be 15 mJ/cm$^2$. The heat resistance of the 0.5 μm line pattern formed from the resist was measured to be at 130 °C.

Example 8

A coating liquid of resist was formed in the same manner as in Example 7, except that SAX (trade name, produced by Mitsui Toatsu Chemical Co.) was used in place of o-nitrobenzoic acid and that 0.128 g of benzophenone were added to the liquid. The properties of the thus-formed resist were evaluated in the same manner as in Example 7. This resist gave a 0.22 μm line-and-space pattern. The cross sectional profile of the resist pattern thus formed was good and rectangular, without being influenced by standing waves. The minimum exposure amount for the resist was measured to be 13 mJ/cm$^2$. The heat resistance of the 0.5 μm line-space pattern formed from the resist was measured to be at 130 °C.

Example 9

A coating liquid of resist was formed in the same manner as in Example 7, except that 0.003 g of o-hydroxy benzoic acid were used in place of o-nitrobenzoic acid and 0. 128 g of benzophenone were then added.

The properties of the thus-formed resist were evaluated in the same manner as in Example 7. This resist gave a 0.2 μ m line-and-space pattern. The cross-sectional profile of the resist pattern thus formed was good and rectangular, without being influenced by standing waves. The minimum exposure amount for the resist was measured to be 7 mJ/cm$^2$. The heat resistance of the 0.5 μm line-space pattern formed from the resist was measured to be at 130 °C.

Example 10

A coating liquid of positive resist was formed in the same manner as in Example 7, except that 1,1-cyclohexanedicarboxylic acid were added to the liquid in place of o-nitrobenzoic acid.

The properties of the thus-formed resist were evaluated in the same manner as in Example 7. This resist gave a 0.21 μm line-and-space pattern. The cross-sectional profile of the resist pattern thus formed was good and rectangular, though somewhat waved but in a negligible degree for practical use. The minimum exposure amount for the resist was 13 mJ/cm$^2$. The heat resistance of the 0.5 μm line-space pattern formed from the resist was measured to be at 130 °C.

Using this resist, a resist pattern was formed as above, except that the resist was, after exposed, left as it was for 30 minutes and then heated at 110 °C for 90 seconds. The resist pattern thus formed was a 0.2 μm line-and-space

pattern having a good, rectangular cross-sectional profile.

Example 11

A coating liquid of positive resis was formed in the same manner as in Example 10, except that 0. 12 g of benzophenone were then added to the liquid. The properties of the thus-formed resist were evaluated in the same manner as in Example 10. This resist gave a 0.21 µm line-and-space pattern. The cross-sectional profile of the resist pattern was good and rectangular without being influenced by standing waves. The minimum exposure amount for the resist was measured to be 13 mJ/cm$^2$. The heat resistance of the 0.5 µm line-space pattern formed from the resist was measured to be at 130 °C.

The resist was, after exposed, left as it was for 30 minutes and then heated at 110 °C for 90 seconds. The resist pattern thus formed was a 0.21 µm line-and-space pattern having a good, rectangular cross sectional profile.

Comparative Example 3

1.05 g of polyhydroxystyrene obtained in Production Example 1, in which 8 % of the hydroxyl groups had been replaced by tert-butoxycarbonyloxy groups, and 1.95 g of polyhydroxystyrene obtained in Production Example 6, in which 8 % of the hydroxyl groups had been replaced by methoxy-n-propyloxy groups, were dissolved in 16.8 g of propylene glycol monomethyl ether acetate, and 0. 21 g of bis(cyclohexylsulfonyl)diazomethane, 0.009 g of o-nitrobenzoic acid and 0. 128 g of benzophenone were added thereto and dissolved. The resulting solution was filtered through a 0.2 µm membrane filter to obtain a coating liquid of positive resist.

The coating liquid thus prepared was tried in the same manner as in Example 7 so as to evaluate the properties of the resist but in vain, since this did not give a resist pattern.

Comparative Example 4

1.05 g of polyhydroxystyrene in Production Example 4, in which 70 % of the hydroxyl groups had been replaced by tert-butoxycarbonyloxy groups, and 1.95 g of polyhydroxy-styrene in Production Example 8, in which 70 % of the hydroxyl groups had been replaced by 1-methoxy-n-propyloxy groups, were dissolved in 16.8 g of propylene glycol monomethyl ether acetate, and 0.21 g of bis(cyclohexylsulfonyl)diazomethane, 0.009 g of SAX (trade name, produced by Mitsui Toatsu Chemical Co.) and 0.128 g of benzophenone were added thereto and dissolved. The resulting solution was filtered through a 0.2 µm membrane filter to obtain a coating liquid of positive resist.

The properties of the thus-formed resist were evaluated in the same manner as in Example 7. The finest patterning limit of the resist was to give a 0.3 µm line-and-space pattern. The cross sectional profile of the pattern given by the resist was not good and T-shaped. The minimum exposure amount for the resist was 20 mJ/cm$^2$. The heat resistance of the 0.5 µm line-space pattern formed from the resist was measured to be at 130 °C.

Comparative Example 5

1.05 g of polyhydroxystyrene in Production Example 1, in which 8 % of the hydroxyl groups had been replaced by tert-butoxycarbonyloxy groups, and 1.95 g of polyhydroxystyrene in Production Example 8, in which 70 % of the hydroxyl groups had been replaced by 1-methoxy-n-propyloxy groups were dissolved in 16.8 g of propylene glycol monomethylether acetate, and 0.21 g of bis(cyclohexylsulfonyl) diazomethane, 0.009 g of phthalic acid and 0.128 g of benzophenone were added thereto and dissolved. The resulting solution was filtered through a 0.2 µm membrane filter to obtain a coating liquid of positive resist.

The properties of the thus-formed resist were evaluated in the same manner as in Example 7. The finest patterning limit of the resist was to give a 0.3 µm line-and-space pattern. The cross sectional profile of the pattern given by the resist was not good, nearly having an inverted triangular shape. The minimum exposure amount for the resist was 10 mJ /cm$^2$. The heat resistance of the 0.5 µm line-space pattern formed from the resist was measured to be at 130 °C.

Example 12

A resist pattern was formed in the same manner as in Example 3, except that a silicon wafer coated with an insulating film of silicon nitride (SiN) was used as the substrate.

The resist pattern thus formed was a 0.23 µm line-and-space pattern. The cross sectional profile of the resist pattern was good and almost rectangular, without being influenced by standing waves.

Example 13

A resist pattern was formed in the same manner as in Example 3, except that a silicon wafer coated with a metallic film of TiN was used as the substrate. The resist pattern thus formed was a 0.23 µm line-and-space pattern. The cross sectional profile of the resist pattern was good and almost rectangular, without being influenced by standing waves.

Example 14

A resist pattern was formed in the same manner as in Example 5, except that a silicon wafer coated with an insulating film of BPSG was used as the substrate. The resist pattern thus formed was a 0.23 µm line-and-space pattern. The cross sectional profile of the resist pattern was good and almost rectangular, without being influenced by standing waves.

Example 15

A resist pattern was formed in the same manner as in Example 1, except that a silicon wafer coated with a metallic film of TiN was used as the substrate. The resist pattern thus formed was a 0.30 µm line-and-space pattern. The cross sectional profile of the resist pattern was expanded downward to the boundary between the pattern and the substrate.

Example 16

0.9g of polyhydroxystyrene obtained in Production Example 3, in which 39 mol% of the hydroxyl groups had been replaced by tert-butoxycarbonyloxy groups, and 2.1 g of polyhydroxystyrene obtained in Production Example 5, in which 35 mol% of the hydroxyl groups had been replaced by ethoxyethoxy groups, were dissolved in 16.8g of propylene glycol monomethyl ether acetate, and 0.15g of pyrogallol trimesylate and 6.3 mg of salicylic acid were added thereto and dissolved. The resulting solution was filtered through a 0.2 µm membrane filter to obtain a coating liquid of positive resist.

The thus-prepared coating liquid was coated on a 6 inches silicon wafer, using a spinner, and dried on a hot plate at 90 °C for 90 seconds to form a resist film having a thickness of 0.7 µm on the wafer. This was subjected to imaging, using an electron bram radiator, HL-8000 (produced by Hitachi, Ltd.), heated at 110 °C for 90 seconds, then developed by paddling it in an aqueous solution of 2.38 % by weight of tetramethylammonium hydroxide for 65 seconds, washed with water for 30 seconds, and dried to form a resist pattern on the wafer. In this way, 0.12 µm contact holes were formed. The cross sectional profile of the resist pattern thus formed was good and rectangular. The exposure amount for this patterning was measured to be 25 $\mu C/cm^2$.

Example 17

A coating liquid of positive resist was prepared in the same manner as in Example 16, except that 0.15 g of bis(p-tert-butylphenyl)iodonium trifluoromethanesulfonate were used as the acid-generating agent in place of pyrogallol trimesylate.

Using this, a resist pattern was formed in the same manner as in Example 16. 0.15 µm contact holes were formed. The cross sectional profile of the resist pattern formed was good and rectangular. The exposure amount for this patterning was 10 $\mu C/cm^2$.

Example 18

A coating liquid of positive resist was prepared in the same manner as in Example 16, except that 0.15 g of 2,6-dinitrobenzyl p-toluenesulfonate were used as the acid-generating agent in place of pyrogallol trimesylate.

Using this, a resist pattern was formed in the same manner as in Example 16. 0.14 µm contact holes were formed. The cross-sectional profile of the resist pattern formed was good and rectangular. The exposure amount for this patterning was 35 $\mu C/cm^2$.

Example 19

A coating liquid of positive resist was prepared in the same manner as in Example 16, except that 0. 15 g of triphenylsulfonium trifluoromethanesulfonate were used as the acid-generating agent in place of pyrogallol trimesylate.

Using this, a resist pattern was formed in the same manner as in Example 16. 0.15 µm contact holes were formed. The cross sectional profile of the resist pattern formed was good and rectangular. The exposure amount for this pat-

terning was 10 μC/cm$^2$.

Example 20

0.9 g of polyhydroxystyrene obtained in Production Example 3, in which 39 mol% of the hydroxyl groups had been replaced by tert-butoxycarbonyloxy groups, and 2.1 g of polyhydroxystyrene obtained in Production Example 7, in which 39 mol% of the hydroxyl groups had been replaced by 1-methoxy-n-propyloxy groups were dissolved in 16.8 g of propylene glycol monomethylether acetate, and 0.03 g of bis(cyclohexylsulfonyl)diazomethane, and 0.15 g of bis (2,4-dimethylphenylsulfonyl)diazomethane )diazomethane and 0.0064 g of o-hydroxybenzoic acid were added thereto and dissolved. The resulting solution was filtered through a 0.2 μm membrane filter to obtain a coating liquid of positive resist.

The properties of the thus-formed resist were evaluated in the same manner as in Example 7. This resist gave a 0.2 μm line-and-space pattern. The cross-sectional profile of the resist pattern thus formed was good and rectangular though somewhat waved but in a negligible degree for practical use. The minimum exposure amount for the resist was measured to be 5 mJ /cm$^2$. The heat resistance of the 0.5 μm line-space pattern formed from the resist was measured to be at 130 °C.

## Claims

1. A positive resist composition comprising (A) a resin component whose solubility in an alkaline aqueous solution is increased by the action of acids, (B) a compound which generates an acid when exposed to radiations, and optionally (C) an organic carboxylic acid compound, wherein said resin component (A) is a mixture comprising (a) a polyhydroxystyrene where from 10 to 60 mol%, preferably from 20 to 50 mol%, of the hydroxyl groups have been replaced by tert-butoxy-carbonyloxy groups and (b) a polyhydroxystyrene where from 10 to 60 mol%, preferably from 20 to 50 mol%, of the hydroxyl groups have been replaced by residues of the following general formula (I):

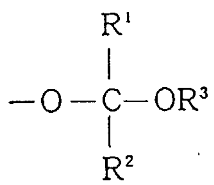

(I)

wherein $R^1$ represents a hydrogen atom or a methyl group, $R^2$ represents a methyl group or an ethyl group, and $R^3$ reprents a lower alkyl group having 1 to 4 carbon atoms.

2. The positive resist composition as claimed in claim 1, in which said component (A) is a mixture comprising from 10 to 70 % by weight, preferably from 20 to 50 % by weight, of the component (a) and from 30 to 90 % by weight, preferably from 50 to 80 % by weight, of the component (b).

3. The positive resist composition as claimed in claim 1, wherein component (B) is at least one selected from the group consisting of bissulfonyldiazomethanes, sulfonylcarbonyl alkanes, sulfonylcarbonyldiazomethanes, nitrobenzyl derivatives, esters of polyhydroxy compounds and aliphatic or aromatic sulfonic acids, onium salt-based acid-generating agents represented by the following general formulas (II) and (III):

$$R^4\text{-}I^+\text{-}R^5X^- \qquad \text{(II)}$$

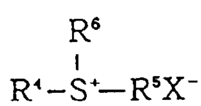

(III)

wherein $R^4$, $R^5$, and $R^6$ are aryl groups or aryl groups having a substituent and may be respectively identical or different; $X^-$ is any $ASF^-_6$, $SbF^-_6$, $PF^-_6$, $BF^-_4$, or $CF_3SO^-_3$,

and benzoin tosylate-based acid-generating agents represented by the general formula (IV):

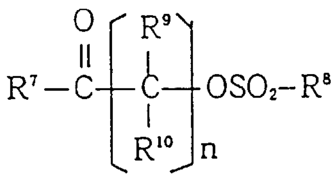

(IV)

wherein $R^7$ and $R^8$ are aryl groups or aryl groups having a substituent and may be identical or different; $R^9$ and $R^{10}$ are hydrogen atoms, lower alkyl groups, hydroxyl groups, or aryl groups and may be identical or different and n is 0 or 1.

**4.** The positive resist composition as claimed in claim 3, wherein the bissulfonyldiazomethanes are at least one selected from the group consisting of bis(cyclohexylsulfonyl)diazomethane and bis(2,4-dimethylphenylsulfonyl) diazomethane.

**5.** The positive resist composition as claimed in claim 3, wherein the nitrobenzyl-based acid-generating agent is 2,6-dinitrobenzyl-p-toluenesulfonate.

**6.** The positive resist composition as claimed in claim 3, wherein the ester of the polyhydroxy compounds and the aliphatic or aromatic sulfonic acid-based acid-generating agent is pyrogallol trimesylate.

**7.** The positive resist composition as claimed in claim 3, wherein the onium salt-based acid-generating agent is selected from bis(p-tert-butylphenyl)iodonium trifluoromethanesulfonate or triphenylsulfonium trifluoromethanesulfonate.

**8.** The positive resist composition as claimed in any of the preceeding claims 1 to 7, wherein the proportion of component (B) is from 1 to 20 parts by weight, preferably from 2 to 10 parts by weight, relative to 100 parts by weight of component (A).

**9.** The positive resist composition as claimed in any of the preceeding claims 1 to 8, which additionally contains a light-absorbing agent.

**10.** The positive resist composition as claimed in claim 9, wherein the light-absorbing agent is at least one selected from the group consisting of mercaptoxazole, mercaptobenzoxazole, mercaptoxazoline, mercaptobenzothiazole, benzoxazoline, benzothiazolone, mercaptobenzimidazole, urazole, thiouracil, mercaptopyrimidine, benzophenone as well as their derivatives, wherein benzophenone is preferred.

**11.** The positive resist composition as claimed in claims 9 and 10, wherein the proportion of the light-absorbing agent in the composition is up to 30 % by weight, preferably from 0.5 to 15 % by weight, relative to the sum of the components (A) and (B).

**12.** The positive resist composition as claimed in claim 1, wherein component (C) is at least one selected from the group consisting of aliphatic mono- or polycarboxylic acids, alicyclic carboxylic acids, unsaturated aliphatic carboxylic acids, hydroxycarboxylic acids, alkoxycarboxylic acids, ketocarboxylic acids, aromatic carboxylic acid compounds represented by the following general formulas (V) and (VI):

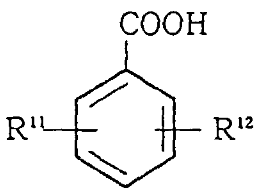

(V)

wherein $R^{11}$ and $R^{12}$ each independently represent a hydrogen atom, a hydroxyl group, a nitro group, a

carboxyl group or a vinyl group, provided that both $R^{11}$ and $R^{12}$ do not represent hydrogen atoms.

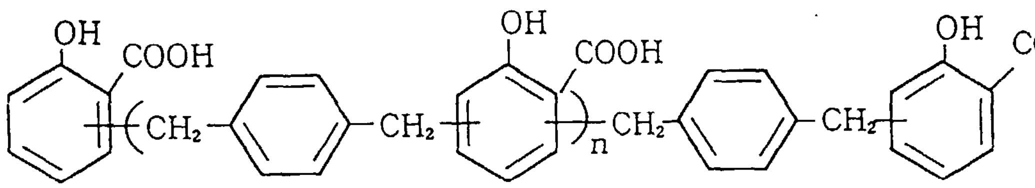

(VI)

wherein n represents 0 or an integer of from 1 to 10.

**13.** The positive resist composition as claimed in claim 12, wherein the alicyclic carboxylic acid is at least one selected from the group consisting of 1,1-cyclohexanedicarboxylic acid, 1,2-cyclohexanedicarboxylic acid, 1,3-cyclohexanedicarboxylic acid, 1,4-cyclohexanedicarboxylic acid, and 1,1-cyclohexyldiacetic acid.

**14.** The positive resist composition as claimed in claim 12, wherein the unsaturated aliphatic carboxylic acid is at least one selected from the group consisting of acrylic acid, crotonic acid, isocrotonic acid, 3-butenoic acid, methacrylic acid, 4-pentenoic acid, propriolic acid, 2-butynoic acid, maleic acid, fumaric acid, and acetylenecarboxylic acid.

**15.** The positive resist composition as claimed in any of the preceeding claims 1 to 14, wherein the proportion of component (C) is from 0.01 to 1 % by weight, preferably from 0.05 to 0.5 % by weight, more preferably from 0.07 to 0.3 % by weight, relative to the sum of the components (A) and (B).

**16.** The positive resist composition as claimed in any of the preceeding claims 1 to 15, wherein said components are dissolved in a solvent.

**17.** Use of the composition according to any of the preceeding claims 1 to 16 for the forming of fine patterns in producing ultra-LSIs.

**Patentansprüche**

**1.** Positive Resistzusammensetzung, umfassend (A) eine Harzkomponente, deren Löslichkeit in einer alkalischen wäßrigen Lösung durch die Einwirkung von Säuren erhöht wird, (B) eine Verbindung, die eine Säure erzeugt, wenn sie Strahlungen ausgesetzt wird, und gegebenenfalls (C) eine organische Carbonsäureverbindung, dadurch gekennzeichnet, daß die Harzkomponente (A) ein Gemisch ist, umfassend (a) ein Polyhydroxystyrol, worin 10 bis 60 Mol-%, vorzugsweise 20 bis 50 Mol-% der Hydroxylgruppen durch tert.-Butoxycarbonyloxygruppen ersetzt sind, und (b) ein Polyhydroxystyrol, worin 10 bis 60 Mol-%, vorzugsweise 20 bis 50 Mol-% der Hydroxylgruppen durch Reste der folgenden allgemeinen Formel (I) ersetzt sind:

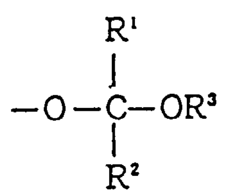

(I)

worin $R^1$ ein Wasserstoffatom oder eine Methylgruppe, $R^2$ eine Methylgruppe oder eine Ethylgruppe, und $R^3$ eine niedere Alkylgruppe mit 1 bis 4 Kohlenstoffatomen darstellen.

**2.** Positive Resistzusammensetzung nach Anspruch 1, dadurch gekennzeichnet, daß die Komponente (A) ein Gemisch ist, das 10 bis 70 Gew.-%, vorzugsweise 20 bis 50 Gew.-% der Komponente (a), und 30 bis 90 Gew.-%, vorzugsweise 50 bis 80 Gew.-% der Komponente (b) umfaßt.

**3.** Positive Resistzusammensetzung nach Anspruch 1, dadurch gekennzeichnet, daß die Komponente (B) wenigstens eine solche ist, die ausgewählt ist aus der Gruppe bestehend aus Bis-Sulfonyldiazomethanen, Sulfonylcarbonylalkanen, Sulfonylcarbonyldiazomethanen, Nitrobenzylderivaten, Estern von Polyhydroxyverbindungen und aliphatischen oder aromatischen Sulfonsäuren, säureerzeugenden Mitteln auf der Basis von Oniumsalzen, die durch die folgenden allgemeinen Formeln (II) und (III) dargestellt sind:

$$R^4\text{-}I^+R^5X^- \qquad (II)$$

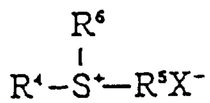

(III)

worin $R^4$, $R^5$ und $R^6$ Arylgruppen oder Arylgruppen mit einem Substituenten sind und jeweils gleich oder verschieden sein können, und $X^-$ irgendeine der Gruppen $AsF^-_6$, $SbF^-_6$, $PF^-_6$, $BF^-_4$ oder $CF_3SO^-_3$ ist,
und säureerzeugenden Mitteln auf Benzointosylatbasis, die durch die allgemeine Formel (IV) dargestellt sind:

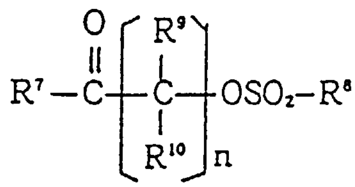

(IV)

worin $R^7$ und $R^8$ Arylgruppen oder Arylgruppen mit einem Substituenten sind und gleich oder verschieden sein können, $R^9$ und $R^{10}$ Wasserstoffatome, niedere Alkylgruppen, Hydroxylgruppen oder Arylgruppen sind und gleich oder verschieden sein können und n 0 oder 1 ist.

4. Positive Resistzusammensetzung nach Anspruch 3, dadurch gekennzeichnet, daß die Bis-sulfonyldiazomethane wenigstens ein solches sind, ausgewählt aus der Gruppe, bestehend aus Bis(cyclohexylsulfonyl)diazomethan und Bis(2,4-dimethylphenylsulfonyl)diazomethan.

5. Positive Resistzusammensetzung nach Anspruch 3, dadurch gekennzeichnet, daß das säureerzeugende Mittel auf Nitrobenzylbasis 2,6-Dinitrobenzyl-p-toluolsulfonat ist.

6. Positive Resistzusammensetzung nach Anspruch 3, dadurch gekennzeichnet, daß der Ester der Polyhydroxyverbindungen und des säureerzeugenden Mittels auf aromatischer Sulfonsäurebasis Pyrogalloltrimesylat ist.

7. Positive Resistzusammensetzung nach Anspruch 3, dadurch gekennzeichnet, daß das säureerzeugende Mittel auf Oniumbasis ausgewählt ist aus Bis(p-tert.-butylphenyl)iodonium-trifluormethansulfonat oder Triphenylsulfonium-trifluormethansulfonat.

8. Positive Resistzussammensetzung nach irgendeinem der vorhergehenden Ansprüche 1 bis 7, dadurch gekennzeichnet, daß der Mengenanteil an Komponente (B) 1 bis 20 Gew.-Teile, vorzugsweise 2 bis 10 Gew.-Teile ist, relativ zu 100 Gew.-Teilen der Komponente (A).

9. Positive Resistzusammensetzung nach irgendeinem der vorhergehenden Ansprüche 1 bis 8, dadurch gekennzeichnet, daß sie zusätzlich ein Licht-absorbierendes Mittel enthält.

10. Positive Resistzusammensetzung nach Anspruch 9, dadurch gekennzeichnet, daß das Licht-absorbierende Mittel wenigstens eines ist, ausgewählt aus der Gruppe bestehend aus Mercaptooxazol, Mercaptobenzoxazol, Mercaptooxazolin, Mercaptobenzthiazol, Benzoxazolin, Benzthiazolon, Mercaptobenzimidazol, Urazol, Thiouracil, Mercaptopyrimidin, Benzophenon sowie ihren Derivaten, wobei Benzophenon bevorzugt ist.

11. Positive Resistzusammensetzung nach Anspruch 9 und 10, dadurch gekennzeichnet, daß der Mengenanteil an Lichtabsorbierendem Mittel in der Zusammensetzung bis zu 30 Gew.-%, vorzugsweise 0,5 bis 15 Gew.-% ist, relativ zur Summe der Komponenten (A) und (B).

**12.** Positive Resistzusammensetzung nach Anspruch 1, dadurch gekennzeichnet, daß die Komponente (C) wenigstens eine solche ist, ausgewählt aus der Gruppe bestehend aus aliphatischen Mono- oder Polycarbonsäuren, alizyklischen Carbonsäuren, ungesättigten aliphatischen Carbonsäuren, Hydroxycarbonsäuren, Alkoxycarbonsäuren, Ketocarbonsäuren, aromatischen Carbonsäureverbindungen, die durch die folgenden allgemeinen Formeln (V) und (VI) dargestellt sind:

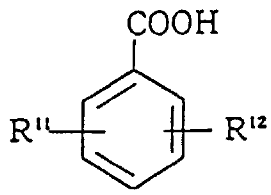

(V)

worin $R^{11}$ und $R^{12}$ jeweils unabhängig voneinander ein Wasserstoffatom, eine Hydroxylgruppe, eine Nitrogruppe, eine Carboxylgruppe oder eine Vinylgruppe darstellen, vorausgesetzt, daß nicht beide $R^{11}$ und $R^{12}$ Wasserstoffatome bedeuten,

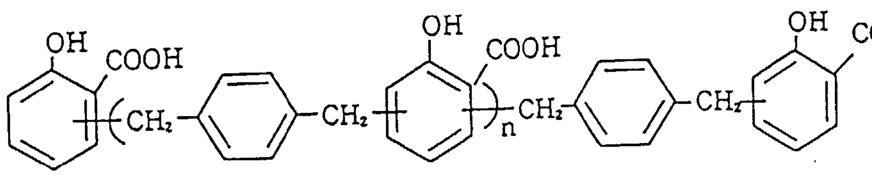

(VI)

worin n 0 oder eine ganze Zahl von 1 bis 10 bedeutet.

**13.** Positive Resistzusammensetzung nach Anspruch 12, dadurch gekennzeichnet, daß die alizyklische Carbonsäure wenigstens eine solche ist, ausgewählt aus der Gruppe bestehend aus 1,1-Cyclohexandicarbonsäure, 1,2-Cyclohexandicarbonsäure, 1,3-Cyclohexandicarbonsäure, 1,4-Cyclohexandicarbonsäure und 1,1-Cyclhexyldiessigsäure.

**14.** Positive Resistzusammensetzung nach Anspruch 12, dadurch gekennzeichnet, daß die ungesättigte aliphatische Carbonsäure wenigstens eine solche ist, ausgewählt aus der Gruppe bestehend aus Acrylsäure, Crotonsäure, Isocrotonsäure, 3-Butensäure, Methacrylsäure, 4-Pentensäure, Propiolsäure, 2-Butinsäure, Maleinsäure, Fumarsäure und Acetylencarbonsäure.

**15.** Positive Resistzusammensetzung nach irgendeinem der vorhergehenden Ansprüche 1 bis 14, dadurch gekennzeichnet, daß der Mengenanteil an Komponente (C) 0,01 bis 1 Gew.-%, vorzugsweise 0,05 bis 0,5 Gew.-%, noch bevorzugter 0,07 bis 0,3 Gew.-% ist, relativ zur Summe der Komponenten (A) und (B).

**16.** Positive Resistzusammensetzung nach irgendeinem der vorhergehenden Ansprüche 1 bis 15, dadurch gekennzeichnet, daß die Komponenten in einem Lösungsmittel gelöst sind.

**17.** Verwendung der Zusammensetzung nach irgendeinem der vorhergehenden Ansprüche 1 bis 16 zur Bildung von feinen Mustern bei der Herstellung von Ultra-LSI-Schaltungen.

**Revendications**

**1.** Composition de résist positif comprenant (A) un composant résineux dont la solubilité dans une solution aqueuse alcaline est augmentée grâce à l'action d'acides, (B) un composé qui génère un acide quand il est exposé à des radiations, et éventuellement (C) un composé acide carboxylique organique, dans laquelle ledit composant résineux (A) est un mélange comprenant (a) un polyhydroxystyrène dans lequel de 10 à 60 % en moles, de préférence de 20 à 50 % en moles, des groupes hydroxyles ont été remplacés par des groupes tert-butoxy-carbonyloxy et (b) un polyhydroxystyrène dans lequel de 10 à 60 % en moles, de préférence de 20 à 50 % en moles, des groupes hydroxyles ont été remplacés par des résidus répondant à la formule générale (I) suivante :

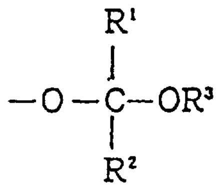

(I)

où $R^1$ représente un atome d'hydrogène ou un groupe méthyle, $R^2$ représente un groupe méthyle ou un groupe éthyle, et $R^3$ représente un groupe alkyle inférieur ayant de 1 à 4 atomes de carbone.

**2.** Composition de résist positif selon la revendication 1, dans laquelle ledit composant (A) est un mélange comprenant de 10 à 70 % en poids, de préférence de 20 à 50 % en poids, de composant (a) et de 30 à 90 % en poids, de préférence de 50 à 80 % en poids, de composant (b).

**3.** Composition de résist positif selon la revendication 1, dans laquelle le composant (B) est au moins un composant choisi dans l'ensemble constitué par les bis-sulfonyldiazométhanes, les sulfonylcarbonylalcanes, les sulfonylcarbonyldiazométhanes, les dérivés de nitrobenzyle, les esters de composés polyhydroxy et d'acides sulfoniques aliphatiques ou aromatiques, les agents comme les sels du type onium générant des acides, représentés par les formules générales (II) et (III) suivantes :

$$R^4\text{-}I^+\text{-}R^5X^- \qquad (II)$$

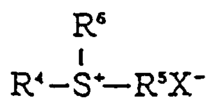

(III)

où $R^4$, $R^5$ et $R^6$ sont des groupes aryles ou des groupes aryles ayant un substituant et peuvent être respectivement identiques ou différents ; X est l'un quelconque de $ASF^-_6$, $SbF^-_6$, $PF^-_6$, $BF^-_4$ ou $CF_3SO^-_3$,
et les agents à base de tosylate de benzoïne générant des acides, représentés par la formule générale (IV) :

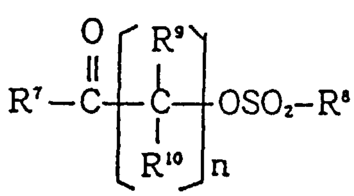

(IV)

où $R^7$ et $R^8$ sont des groupes aryles ou des groupes aryles ayant un substituant et peuvent être identiques ou différents ; $R^9$ et $R^{10}$ sont des atomes d'hydrogène,
des groupes alkyles inférieurs, des groupes hydroxyles ou des groupes aryles et peuvent être identiques ou différents, et n vaut 0 ou 1.

**4.** Composition de résist positif selon la revendication 3, dans laquelle les bis-sulfonyldiazométhanes sont au moins un composé choisi dans l'ensemble constitué par le bis(cyclohexylsulfonyl)diazométhane et le bis(2,4-diméthylphénylsulfonyl)diazométhane.

**5.** Composition de résist positif selon la revendication 3, dans laquelle l'agent générant des acides, à base de nitrobenzyle, est le p-toluène-sulfonate de 2,6-dinitrobenzyle.

**6.** Composition de résist positif selon la revendication 3, dans laquelle l'ester des composés polyhydroxy et l'agent générant des acides, à base d'acide sulfonique aliphatique ou aromatique, est le trimésylate de pyrogallol.

**7.** Composition de résist positif selon la revendication 3, dans laquelle l'agent générant des acides, à base de sel du

type onium, est choisi parmi le trifluorométhanesulfonate de bis(p-tert-butylphényl)iodonium ou le trifluorométhanesulfonate de triphénylsulfonium.

8. Composition de résist positif selon l'une quelconque des revendications précédentes 1 à 7, dans laquelle la proportion de composant (B) est de 1 à 20 parties en poids, de préférence de 2 à 10 parties en poids, pour 100 parties en poids de composant (A).

9. Composition de résist positif selon l'une quelconque des revendications précédentes 1 à 8, contenant, en outre, un agent absorbant la lumière.

10. Composition de résist positif selon la revendication 9, dans laquelle l'agent absorbant la lumière est au moins un composé choisi dans l'ensemble constitué par le mercaptoxazole, le mercaptobenzoxazole, la mercaptoxazoline, le mercaptobenzothiazole, la benzoxazoline, la benzothiazolone, le mercaptobenzimidazole, l'urazole, le thiouracile, la mercaptopyrimidine, la benzophénone, ainsi que leurs dérivés, la benzophénone étant préférée.

11. Composition de résist positif selon les revendications 9 et 10, dans laquelle la proportion d'agent absorbant la lumière dans la composition vaut jusqu'à 30 % en poids, de préférence de 0,5 à 15 % en poids, par rapport à la somme des composants (A) et (B).

12. Composition de résist positif selon la revendication 1, dans laquelle le composant (C) est au moins un composant choisi dans l'ensemble constitué par les acides mono- ou polycarboxyliques aliphatiques, les acides carboxyliques alicycliques, les acides carboxyliques aliphatiques insaturés, les acides hydroxycarboxyliques, les acides alcoxycarboxyliques, les acides cétocarboxyliques, les composés d'acides carboxyliques aromatiques représentés par les formules générales (V) et (VI) suivantes :

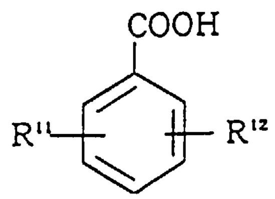

(V)

où $R^{11}$ et $R^{12}$ représentent chacun indépendamment un atome d'hydrogène, un groupe hydroxyle, un groupe nitro, un groupe carboxyle ou un groupe vinyle, avec la condition que $R^{11}$ et $R^{12}$ ne représentent pas tous les deux des atomes d'hydrogène,

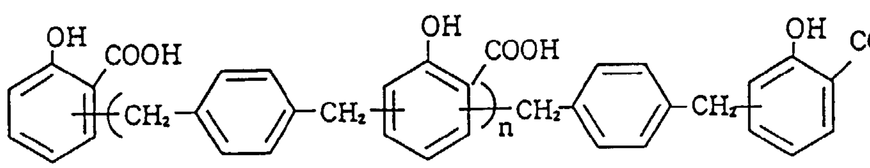

(VI)

où n représente 0 ou un nombre entier de 1 à 10.

13. Composition de résist positif selon la revendication 12, dans laquelle l'acide carboxylique alicyclique est au moins un élément choisi dans l'ensemble constitué par l'acide 1,1-cyclohexanedicarboxylique, l'acide 1,2-cyclohexanedicarboxylique, l'acide 1,3-cyclohexanedicarboxylique, l'acide 1,4-cyclohexanedicarboxylique et l'acide 1,1-cyclohexyldiacétique.

14. Composition de résist positif selon la revendication 12, dans laquelle l'acide carboxylique aliphatique insaturé est au moins un élément choisi dans l'ensemble constitué par l'acide acrylique, l'acide crotonique, l'acide isocrotonique, l'acide 3-buténoïque, l'acide méthacrylique, l'acide 4-penténoïque, l'acide propriolique, l'acide 2-butynoïque, l'acide maléique, l'acide fumarique et l'acide acétylènecarboxylique.

15. Composition de résist positif selon l'une quelconque des revendications précédentes 1 à 14, dans laquelle la proportion de composant (C) est de 0,01 à 1 % en poids, de préférence de 0,05 à 0,5 % en poids, d'une manière

plus préférée de 0,07 à 0,3 % en poids, par rapport à la somme des composants (A) et (B).

**16.** Composition de résist positif selon l'une quelconque des revendications précédentes 1 à 15, dans laquelle lesdits composants sont dissous dans un solvant.

**17.** Utilisation de la composition selon l'une quelconque des revendications précédentes 1 à 16 pour la formation de motifs fins lors de la production de circuits ULSI.